Europäisches Patentamt

European Patent Office

Office européen des brevets

(19)

(11) **EP 0 902 562 A2**

(12) **EUROPÄISCHE PATENTANMELDUNG**

(43) Veröffentlichungstag:
17.03.1999 Patentblatt 1999/11

(51) Int. Cl.⁶: **H04B 15/04**, H04L 5/06

(21) Anmeldenummer: 98110788.1

(22) Anmeldetag: 12.06.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 12.09.1997 DE 19740185

(71) Anmelder: ROBERT BOSCH GMBH
70442 Stuttgart (DE)

(72) Erfinder: Drinda, Klaus
71522 Backnang (DE)

(54) **Schaltungsanordnung zum Zusammenfassen von an Eingängen eines Sammlers anliegenden Signalen zu einem Ausgangssignal**

(57)    Die Erfindung betrifft eine Schaltungsanordnung zum Zusammenfassen von an Eingängen
eines Sammlers anliegenden Signalen, insbesondere
von Modems, zu einem Ausgangssignal.

Es ist vorgesehen, daß die Eingänge (12) in zwei
Gruppen von Eingängen (12, 12') gesplittet werden, und
die Eingangssignale (Tx1 bis Txm) einer ersten Gruppe
(16) auf einen invertierenden Eingang (20) und die Eingangssignale (Txm+1 bis Tx2m) einer zweiten Gruppe
(18) auf einen nichtinvertierenden Eingang (22) einer
spannungsgegengekoppelten Emitterstufe (24) summiert werden.

Fig. 1

EP 0 902 562 A2

## Beschreibung

Die Erfindung betrifft eine Schaltungsanordnung zum Zusammenfassen von an Eingängen eines Sammlers anliegenden Signalen zu einem Ausgangssignal mit den im Oberbegriff des Anspruchs 1 genannten Merkmalen.

Stand der Technik

Es ist bekannt, in einem Netz eingespeiste Sendesignale, beispielsweise von Modems, in Sammlern (Modem shelf combiner) zusammenzufassen und das zusammengefaßte Signal in eine Übertragungsstrecke einzuspeisen. Die Nutzsignalanteile der Sendesignale werden hierbei problemlos überlagert, da die Trägersignale der einzelnen Modems in unterschiedlichen Frequenzbereichen arbeiten. Nachteilig ist jedoch, daß mit der Übertragung der Nutzsignale miteinander korrelierte Störsignale übertragen werden, die gleiche Frequenz- und gleiche Phasenlage besitzen. Dies resultiert insbesondere aus der Verwendung eines zentralen Clocksignals zur Synchronisierung der Modems. Jedes Modem erzeugt Störer durch die digitale Signalverarbeitung. Da ein zentraler Clock verwendet wird, sind die Störer aller Modems in Frequenz und Phase identisch, das heißt korreliert. Da die Störer korreliert sind, werden sie spannungsmäßig addiert. Dies führt zu einer unzulässigen Verschlechterung des Störabstandes des Übertragungssystems.

Vorteile der Erfindung

Die erfindungsgemäße Schaltungsanordnung mit den im Anspruch 1 genannten Merkmalen bietet den Vorteil, daß an mehreren Eingängen des Sammlers anliegende nichtkorrelierte Sendesignale zusammenfaßbar, und diesen anhaftende korrelierte Störsignale kompensierbar sind. Dadurch, daß die Eingangssignale in zwei Gruppen von Eingangssignalen gesplittet werden und die Eingangssignale einer ersten Gruppe auf einen invertierenden Eingang und die Eingangssignale einer zweiten Gruppe auf einen nichtinvertierenden (Eingangstransistor arbeitet nun als Basisstufe) Eingang einer spannungsgegengekoppelten Emitterstufe summiert werden, ist vorteilhaft möglich, die mit gleicher Frequenz behafteten Störsignale gegenphasig zu überlagern, so daß diese sich gegenseitig kompensieren. Die Inversion eines Teils der Eingangssignale hat auf die Übertragung der Nutzsignale keinen Einfluß, da deren Träger jeweils andere Frequenzen nutzen.

Weiter vorteilhafte Ausgestaltungen der Erfindung ergeben sich aus den übrigen, in den Unteransprüchen genannten Merkmalen.

Zeichnungen

Die Erfindung wird nachfolgend in einem Ausführungsbeispiel anhand der zugehörigen Zeichnungen näher erläutert. Es zeigen:

Figur 1 und Figur 2    eine Schaltungsanordnung zum Zusammenfassen von mehreren Eingangssignalen in zwei Darstellungsvarianten;

Figur 3    eine Ausführung mit Cascode-Stufe und

Figur 4    Mittel zur Anhebung des Amplitudenfrequenzganges.

Beschreibung des Ausführungsbeispiels

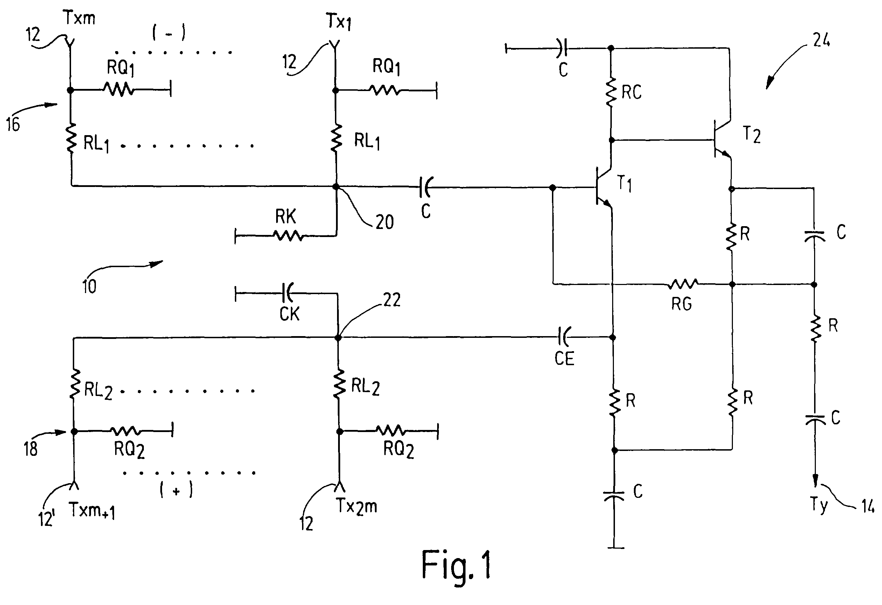

Figur 1 zeigt eine Schaltungsanordnung 10 zum Zusammenfassen von an Eingängen 12 anliegenden Eingangssignalen Tx zu einem an einem Ausgang 14 anliegenden Ausgangssignal Ty. Die Eingangssignale Tx sind beispielsweise die Sendesignale von Modems eines Netzes, die als gemeinsames Ausgangssignal Ty auf eine Übertragungsstrecke gesendet werden. Die Eingänge 12 sind hierbei in zwei Gruppen von Eingängen aufgeteilt. Eine erste Gruppe 16 umfaßt die Eingänge 12, während eine zweite Gruppe die Eingänge 12' umfaßt. An den Eingängen 12 liegen die Eingangssignale $Tx_1$ bis Txm an, die in einem Knotenpunkt 20 zusammengeführt sind. An den Eingängen 12' liegen die Eingangssignale Txm+1 bis Tx2m an, die in einem Knotenpunkt 22 zusammengeführt sind. Die Knotenpunkte 20 und 22 sind mit einer spannungsgegengekoppelten Emitterstufe 24 verbunden. Hierbei ist der Knotenpunkt 20 mit der Basis eines Eingangstransistors $T_1$ und der Knoten 22 mit dem Emitter des Eingangstransistors $T_1$ verbunden. Dem Eingangstransistor $T_1$ ist ein weiterer Transistor $T_2$ zugeordnet, der als Collectorstufe arbeitet (Treiber für die niederohmige Ausgangslast). Hierbei ist die Basis des zweiten Transistors $T_2$ mit dem Kollektor des Eingangstransistors $T_1$ verbunden.

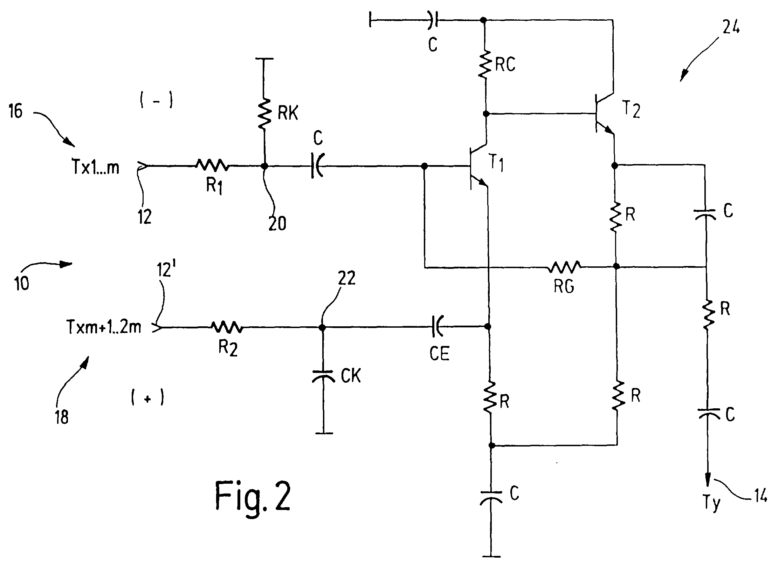

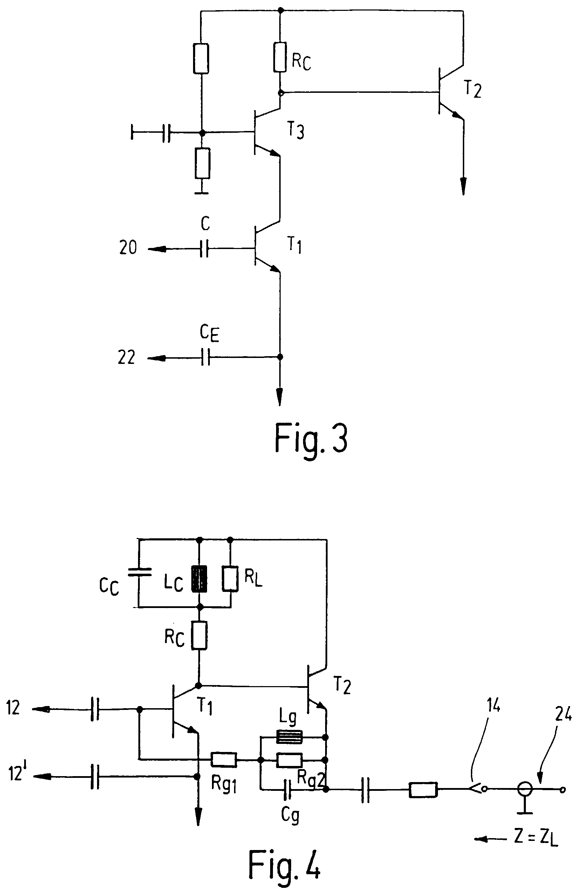

In Figur 2 ist die Schaltungsanordnung gemäß Figur 1 in einer eingangsseitig zusammengefaßten Variante dargestellt. Im übrigen sind gleiche Teile mit gleichen Bezugszeichen versehen und nicht nochmals erläutert. An den Eingängen 12 liegen die Eingangssignale Tx1 bis Txm und am Eingang 12' die Eingangssignale Txm+1 bis Tx2m an. Bekannte Schaltungsanordnungen 10 für Sammler fassen beispielsweise sechzehn (2m) Eingangssignale Tx zusammen. Gemäß der in den Figuren 1 und 2 gezeigten Schaltungsanordnung ist nunmehr vorgesehen, hiervon acht (m) Eingangssignale Tx1 bis Txm auf die Eingänge 12 und weitere 8 (n) Eingangssignale Txm+1 bis Tx2m auf die Eingänge 12' zu schalten. Der Knotenpunkt 20, der einen Eingang der Emitterstufe 24 bildet, dient als invertierender Eingang, während der Knoten 22 als nichtinvertierender Eingang der Emitterstufe 24 dient (T1 arbeitet jetzt als Basisstufe). Die Verstärkung des invertierenden Einganges wird durch die Spannungsgegenkopplung gemäß des Verhältnisses der Widerstände $RG/R_1$ und das Verhältnis der Widerstände $RC/R_2$ bestimmt. Die Verstärkung des nichtinvertierenden Einganges wird durch das Verhältnis der Widerstände $RC/R_2$ und die Spannungsgegenkopplung entsprechend der Widerstände $1+RG/R_1$ bestimmt. Die Verhältnisse der Widerstände $RC/R_2$ und $RG/R_1$ werden so dimensioniert, daß die Verstärkung in beiden Zweigen, also über den invertierenden Eingang und den nichtinvertierenden Eingang, gleiche Beträge aufweist. Durch die Aufteilung der Eingänge 12 beziehungsweise 12' auf den invertierenden beziehungsweise nichtinvertierenden Eingang der Emitterstufe 24 wird erreicht, daß sich die Phasen der Verstärkungen in den beiden Zweigen um 180° unterscheiden. Hierdurch wird erreicht, daß die den Eingangssignalen Tx neben den nichtkorrelierten Nutzsignalen anhaftenden korrelierten Störsignale aufgrund deren gleicher Frequenz- und Phasenlage kompensiert werden. Durch Dimensionierung der Kapazität CK kann der Amplitudenfrequenzgang und die Phase des nichtinvertierenden Zweiges der Schaltungsanordnung 10 optimiert werden, während durch Dimensionierung des Widerstand RK am invertierenden Zweig der Schaltungsanordnung 10 Verstärkungsunterschiede ausgeglichen werden können. Durch die in Figur 3 gezeigte optionale Schaltung des Transistors $T_3$ (Cascodestufe) wird erreicht, daß die Bandbreite der Schaltungsanordnung 10 bis in den VHF-Bereich erweitert werden kann. Die übrigen Schaltungsbestandteile entsprechen der in den Figuren 1 und 2 gezeigten Schaltungsanordnung.

Insgesamt ist es also möglich, am Ausgangsanschluß 14 ein summiertes Signal der Eingangssignale Tx bereitzustellen, bei dem durch die Kompensation über die Aufteilung auf den invertierenden und den nichtinvertierenden Eingang der Emitterstufe 24 die Störsignale weitgehend kompensiert sind.

Um die Kompensation der Störanteile zu erreichen, müssen die Eingänge 12 beziehungsweise 12' entkoppelt sein, das heißt, ein Leerlauf oder ein Abschluß der Eingänge dürfen keine wesentliche Verstärkungsänderung ergeben. Die Entkopplung und die Durchgangsdämpfung der Eingänge wird über das Verhältnis der Widerstände RQ/RL der einzelnen Eingänge 12 beziehungsweise 12' (Figur 1) bestimmt. Die Parallelschaltung der Widerstände RQ und RL ergibt die Eingangsimpedanz der Eingänge Tx1 ....Tx2m.

Nach unterschiedlichen Ausführungsbeispielen kann vorgesehen sein, daß alle invertierenden Eingänge 12 und alle nichtinvertierenden Eingänge 12' eine gleiche Eingangsdämpfung aufweisen, beziehungsweise einander paarweise zugeordnete invertierende beziehungsweise nichtinvertierende Eingänge besitzen die gleiche Eingangsdämpfung, wobei die Eingangsdämpfung verschiedener Paare unterschiedlich sein kann. Beispielsweise besitzt ein erstes Paar eines Einganges 12 und eines Einganges 12' eine Eingangsdämpfung von 6 dB ein zweites Paar von Eingängen 12 beziehungsweise 12' eine Eingangsdämpfung von 10 dB und so weiter. Entscheidend ist, daß die Summe aller Eingangsdämpfungen des invertierenden und des nichtinvertierenden Zweiges der Schaltungsanordnung gleich groß ist, damit eine Kompensation der Störanteile erfolgen kann.

Die in Figur 1 und 2 gezeigte Schaltungsanordnung 10 bildet einen Sammler von beispielsweise insgesamt sechzehn Eingangssignalen Tx, wobei ein Ausgangssignal Ty erzeugt wird. In einem übergeordneten Sammler können die Ausgangssignale Ty wiederum unter den gleichen Bedingungen, das heißt, an einen nichtinvertierenden und einen invertierenden Eingang einer übergeordneten Schaltungsanordnung 10 gelegt werden, so daß eine weitere Zusammenfassung der Signale zu einem gemeinsamen Ausgangssignal möglich ist. So können die erfindungsgemäßen Schaltungsanordnungen 10 beispielsweise in Sammlern eingesetzt werden, bei denen Sendesignale von beispielsweise 144 Modems durch neun Schaltungsanordnungen 10 mit jeweils sechzehn Eingängen 12 beziehungsweise 12' und einer übergeordneten Schaltungsanordnung, an die zu den neun vorzusammengefaßten Sendesignale nochmals sieben weitere Sendesignale summiert werden können, so daß insgesamt 151 Sendesignale zusammenfaßbar sind.

Nach weiteren Ausführungsbeispielen kann vorgesehen sein, daß die Anzahl der Eingänge 12 beziehungsweise 12' beziehungsweise die Anzahl der belegten Eingänge 12 beziehungsweise 12' variieren. So können beispielsweise acht Eingänge 12 und sieben Eingänge 12' belegt sein, das heißt, die Anzahl der Eingänge ist unsymmetrisch. Hierdurch wird zwar der Wirkungsgrad der Kompensation der Störanteile beeinträchtigt, jedoch der Störanteil im Ausgangssignal immer noch erheblich reduziert. Um so größer die Gesamtzahl der Eingänge ist, wobei auch mehr als sechzehn Eingänge 12, 12' vorgesehen sein können, um so geringer ist der Einfluß einer unsymmetrischen Belegung.

In Figur 4 ist die Schaltungsanordnung 10 ausschnittsweise in einer abgewandelten Variante gezeigt. Hierbei liegt der Widerstand RC in Reihe mit einer Parallelschaltung eines Widerstandes RL einer Induktivität LC und einer Kapazität CC. Ferner ist der Widerstand RG durch eine Reihenschaltung des Widerstandes $RG_1$ mit einer Parallelschaltung eines Widerstandes $RG_2$ mit einer Induktivität LG und einer Kapazität CG ersetzt. Durch diese Modifizierung des Kollektorzweiges und des Gegenkoppelzweiges der Schaltungsanordnung 10 wird erreicht, daß eine Anhebung des Amplitudenfrequenzganges im invertierenden Zweig und im nichtinvertierenden Zweig gleich ist. Der Betrag der Anhebung des Amplitudenfrequenzganges wird hierbei bestimmt durch die Verhältnisse von RL/RC beziehungsweise $RG_1/RG_2$. Der Verlauf über der Frequenz wird bestimmt durch die Resonanzfrequenz und das Verhältnis $\sqrt{\frac{L}{C}}$ der Induktivität LC und der Kapazität CC beziehungsweise der Induktivität Lg und der Kapazität Cg.

In Figur 4 ist ferner am Ausgangsanschluß 14 eine angeschlossene Verbindungsleitung, beispielsweise ein Koaxialkabel 24, angedeutet, wobei eine Ausgangsimpedanz Z gleich dem Wellenwiderstand $Z_L$ des Koaxialkabels 24 entspricht. Diese beträgt beispielsweise 75 $\Omega$.

## Patentansprüche

1. Schaltungsanordnung zum Zusammenfassen von an Eingängen eines Sammlers anliegenden Signalen, insbesondere von Modems, zu einem Ausgangssignal, **dadurch gekennzeichnet**, daß die Eingänge (12) in zwei Gruppen von Eingängen (12, 12') gesplittet werden, und die Eingangssignale (Tx1 bis Txm) einer ersten Gruppe (16) auf einen invertierenden Eingang (20) und die Eingangssignale (Txm+1 bis Tx2m) einer zweiten Gruppe (18) auf einen nichtinvertierenden Eingang (22) einer spannungsgegengekoppelten Emitterstufe (24) summiert werden.

2. Schaltungsanordnung nach Anspruch 1, **dadurch gekennzeichnet**, daß eine Verstärkung des invertierenden Eingangs (20) durch eine Spannungsgegenkopplung über das Verhältnis der Widerstände ($RG/R_1$) und das Verhältnis der Widerstände ($RC/R_2$) einstellbar ist.

3. Schaltungsanordnung nach einem der vorhergehenden Ansprüche, **dadurch gekennzeichnet**, daß eine Verstärkung des nichtinvertierenden Einganges (22) durch eine Spannungsgegenkopplung über das Verhältnis der Widerstände ($1+RG/R_1$) und das Verhältnis der Widerstände ($RC/R_2$) einstellbar ist.

4. Schaltungsanordnung nach einem der vorhergehenden Ansprüche, **dadurch gekennzeichnet**, daß die Verstärkung im invertierenden und nichtinvertierenden Zweig der Schaltungsanordnung (10) gleich groß ist.

5. Schaltungsanordnung nach einem der vorhergehenden Ansprüche, **dadurch gekennzeichnet**, daß ein Eingangstransistor ($T_1$) mit einem zweiten Transistor ($T_3$) zu einer Cascodenstufe geschaltet ist.

6. Schaltungsanordnung nach einem der vorhergehenden Ansprüche, **dadurch gekennzeichnet**, daß die invertierenden Eingänge (12) und die nichtinvertierenden Eingänge (12') alle eine gleiche Eingangsdämpfung aufweisen.

7. Schaltungsanordnung nach einem der vorhergehenden Ansprüche, **dadurch gekennzeichnet**, daß jeweils paarweise einander zugeordnete invertierende Eingänge (12) und nicht invertierende Eingänge (12') eine gleiche Eingangsdämpfung aufweisen.

8. Schaltungsanordnung nach einem der vorhergehenden Ansprüche, **dadurch gekennzeichnet**, daß zur Optimierung einer 180°-Phasendifferenz der beiden Gruppen von Eingängen (12, 12') im nichtinvertierenden Zweig eine Kapazität ($C_K$) geschaltet ist.

9. Schaltungsanordnung nach einem der vorhergehenden Ansprüche, **dadurch gekennzeichnet**, daß zur Optimierung des Verstärkungsgleichlaufes im invertierenden und nichtinvertierenden Zweig im invertierenden Zweig ein Widerstand ($R_K$) geschaltet ist.

Fig.1

Fig.2

Fig. 3

Fig. 4